# EUROPÄISCHE PATENTSCHRIFT

(11) **EP 0 397 898 B1**
(45) Veröffentlichungstag und Bekanntmachung des Hinweises auf die Patenterteilung: **27.07.1994**
(21) Anmeldenummer: 89108693.6
(22) Anmeldetag: 13.05.1989
(51) Int. Cl.: H01L 21/60

(54) **Bipolarer Bump-Transistor und Verfahren zur Herstellung**
Bipolar Bump transistor and method for its manufacture
Transistor bipolaire avec des plots et procédé pour sa fabrication

(43) Veröffentlichungstag der Anmeldung: 22.11.1990
(73) Patentinhaber: Deutsche ITT Industries GmbH, 79108 Freiburg (DE)
(72) Erfinder: Paschke, Klaus, Phys.-Ing., D-7832 Kenzingen (DE); Zipfel, Roland, D-7800 Freiburg-Tiengen (DE)

(56) Entgegenhaltungen:
- EP-A- 0 229 426
- DE-A- 2 606 885
- GB-A- 1 199 448
- GB-A- 2 004 686
- US-A- 4 187 599

## Beschreibung

Die Erfindung betrifft einen bipolaren Bump-Transistor gemäß Anspruch 1 sowie ein Verfahren zu dessen Herstellung.

Aus statischen Gründen, wegen der mechanischen Beanspruchung, wie auch aus elektrischen Gründen, wegen der Anschlußkontakte, werden wie andere Halbleiterbauelemente so auch Transistoren im Verlauf des Herstellungsverfahrens auf einem Metallband (leadframe) befestigt. Dies geschieht für gewöhnlich durch Kleben, Löten oder Legieren, wobei das Siliciumplättchen, das das Bauelement enthält, mit einer seiner Hauptflächen, nämlich der Rückseite, auf der verbreiteteren Fläche einer der Zuleitungen des Metallbandes angebracht wird. Um einen besseren elektrischen Kontakt bzw. Wärmeübergang zu erreichen, wird die Rückseite metallisiert, dies gilt für integrierten Schaltungen wie auch für Einzeltransistoren. Beim Einzeltransistor ist dabei die Rückseite üblicherweise der Kollektoranschluß, Basis und Emitter werden mittels der herkömmlichen Drahtkontaktierungen (Bonden) mit den zugehörigen, nach der Verkapselung nach außen führenden Elektroden verbunden.

Das beschriebene Verfahren weist eine Reihe von Nachteilen auf. So muß z.B. die Rückseite des Siliciumplättchens vor dem Metallisieren geätzt oder geschliffen werden, um eine ebene Fläche zu bekommen. Außerdem ist es zeitraubend und teuer, eine Vielzahl von Plättchen über Einzeldrähte (Bonddrähte) mit den entsprechenden Elektroden zu verbinden. Bekanntermaßen stellen heute die Montagekosten einen großen Teil der Gesamtkosten der fertigen Halbleiterbauelemente dar.

Es wurden deshalb eine Reihe von Verfahren entwickelt, um die Drahtkontaktierung zu umgehen und gleichzeitig eine Automatisierung der Montage und Kontaktierung zu ermöglichen. Stellvertretend für diese Verfahren sind in I.Ruge Halbleitertechnologie, Springer-Verlag Berlin 1975 die nachfolgenden drei Möglichkeiten beschrieben.

Die Plättchen-Schnellmontage-Technik ("flip-chip"-Technik) besteht darin, Kontaktflecke am Rande des Halbleiterplättchens erhöht, als sogenannte Bumps, auszubilden. Zur Befestigung des Plättchens auf dem Träger wird dieses mit der Kontaktseite nach unten direkt auf dem Träger montiert, der ein entsprechendes Zuleitungsmuster trägt, siehe GB-A-2004 686

Ein anderes Verfahren ist die sogenannte Stege-Technik ("beam-lead"-Technik). Sie unterscheidet sich von den anderen Montagetechniken dadurch, daß die Zuführungen zu den Kontaktflecken am Rande der Scheibe stabil ausgebildet sind und das Halbleiterplättchen mit den Zuführungen auf dem Träger montiert wird. Das Verfahren ist verhältnismäßig aufwendig, insbesondere die Herstellung der Stege erfordert eine Vielzahl von Arbeitsschritten.

Eine dritte Möglichkeit ist die sogenannte Spinnentechnik ("spider-grid"-Technik), bei der die als Träger dienenden Zuführungen oder Elektroden im Gegensatz zur Stegetechnik unabhängig von der Plättchenherstellung erzeugt werden. Man hat im Prinzip ein Leitbahnenmuster, an dem das Halbleiterplättchen über entsprechende Kontaktflecken befestigt wird.

Allen drei beschriebenen Verfahren ist gemeinsam, daß sie nur bei integrierten Schaltungen Verwendung finden, wobei insbesondere die beiden ersteren vom Verfahrensablauf auch so aufwendig sind, daß sie gegenüber der herkömmlichen Bond-Technik von der Kostenseite keine Vorteile bei Einzelhalbleiterbauelementen wie Transistoren bringen. Aus diesem Grunde und wegen der herkömmlichen Struktur von Transistoren hat man bislang am bewährten Verfahren der Drahtbondung festgehalten, siehe GB-A-1199448.

Die in den Ansprüchen gekennzeichnete Erfindung löst die Aufgabe, einen Transistor anzugeben, der sich bei Sicherstellung der kritischen elektrischen Parameter wie Sättigung und Hochstromverhalten für eine billige Montagetechnik eignet. Ferner liegt es im Rahmen der Erfindung, ein entsprechendes Verfahren zur Herstellung eines derartigen Transistors anzugeben.

Die Vorteile der Erfindung liegen einmal in der Lösung der Aufgabe selbst, außerdem wird ein Transistor erhalten, der eine sehr gute Wärmeableitung besitzt, da die Wärme über den Emitter-Kontakt-Bump direkt abgeführt wird. Als weitere Vorteile sind zu nennen: Die Selbstjustierung der Metallkontakte, der Wegfall des Schleifens bzw. Ätzens der Rückseite und deren Metallisierung bei den Wafern, die Einsparung von Photoprozessen gegenüber den herkömmlichen Verfahren bei der Herstellung der Kontakt-Bumps sowie die Möglichkeit, die Konfiguration der Emitter- und der Basisrandlänge den jeweiligen angestrebten elektrischen Eigenschaften des Transistors anzupassen.

Andere "Bump"-Anschluß-Strukturen sind in EP-A-229426 beschreiben.

Die Erfindung wird nun anhand der Figuren der Zeichnung eines bevorzugten Ausführungsbeispiels näher erläutert:
Fig.1 zeigt die Draufsicht auf einen bipolaren Bump-Transistor nach der Erfindung,
Fig.2 zeigt die Schnittansicht längs der Linie A-A in Fig.1,
Figuren 3 bis 6 zeigen schematisch in Schnittansicht das jeweilige Ergebnis von Verfahrensschritten während der Herstellung des Transistors nach Fig.2.

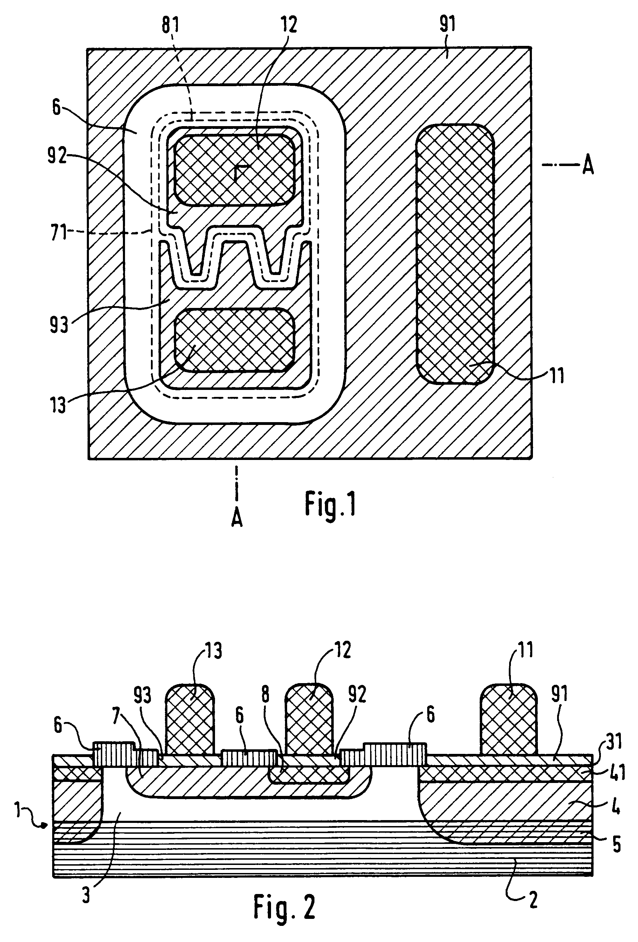

Bei der in Fig.1 dargestellten Draufsicht auf einen bipolaren Bump-Transistor nach der Erfindung ist eine Metallschicht 91 gezeigt, die große Teile der ersten Hauptfläche (Oberfläche) des Transistors bedeckt und unter der die in der Draufsicht nicht sichtbare Kollektorzone 4 liegt. Man erkennt, daß in der Metallschicht 91 eine Fläche ausgespart ist, in der zwei weitere Metallschichten 92, 93 angeordnet sind. Alle drei Metallschichten 91, 92, 93 werden durch eine Isolierschicht 6, im vorliegenden Beispiel eine Siliciumdioxidschicht, voneinander getrennt. Die Verwendung eines anderen Isoliermaterials,wie z.B. Siliciumnitrid, liegt im Rahmen der Erfindung. Die Metallschicht 93 bedeckt einen Teil der nicht sichtbaren Basiszone 7, deren Berandung durch die gestrichelte Linie 71 angedeutet ist. In der Basiszone 7 ist wiederum die ebenfalls nicht sichtbare Emitterzone 8 eingelassen, deren Berandung durch die gestrichelte Linie 81 angedeutet ist. Die Emitterzone 8 wird weitgehend von der Metallschicht 92 abgedeckt. Auf den Metallschichten 91, 92, 93 befinden sich die zu den jeweiligen darunterliegenden aktiven Zonen zugehörenden Kontakt-Bumps, wobei der Kontakt-Bump 11 der Kollektorzone, der Kontakt-Bump 12, der Emitterzone und der Kontakt-Bump 13 der Basiszone zugehört. Man erkennt aus der Fig.1, daß die Emitterzone und damit auch die Basiszone vollständig von der Kollektorzone eingerahmt sind und daß in dem dargestellten Ausführungsbeispiel Emitter- und Basiszone zur Randlinienvergrößerung fingerförmig ineinandergreifen.

In der den Schnitt nach A-A in Fig.1 darstellenden Fig.2 ist der Grundkörper 1 gezeigt, der sich aus einer unteren hochdotierten Schicht 2 von n⁺⁺-Leitfähigkeit und einer oberen Schicht 3 des gleichen Leitungstyps, jedoch gegenüber der unteren Schicht 2 niedrigerer Dotierung, also n-Leitfähigkeit, zusammensetzt. In dem Grundkörper 1 ist von seiner Oberseite 31 (erste Hauptfläche) her eine Zone von dessen Leitungstyp, nämlich die Kollektorzone mit n⁺-Leitfähigkeit, unter Ausparung eines Mittelbereiches derart eingelassen, daß die Kollektorzone 4 bis in die untere Schicht 2 reicht. In den freien Mittelbereich erstreckt sich von der Oberseite 31 her die Basiszone 7 von p-Leitfähigkeit, in die wiederum eine Zone von n⁺-Leitfähigkeit, nämlich die Emitterzone 8, von der Oberseite 31 eingelassen ist. Auf der höher dotierten Oberflächenschicht 41 der Kollektorzone 4 ist die Metallschicht 91 angeordnet, die den Kontakt-Bump 11 trägt. Entsprechend ist auf der Emitterzone 8 die Metallschicht 92 mit dem Kontakt-Bump 12 und auf der Basiszone 7 die Metallschicht 93 mit dem Kontakt-Bump 13 angeordnet. Zwischen den Metallschichten 91, 92, 93 liegt die Siliciumdioxidschicht 6.

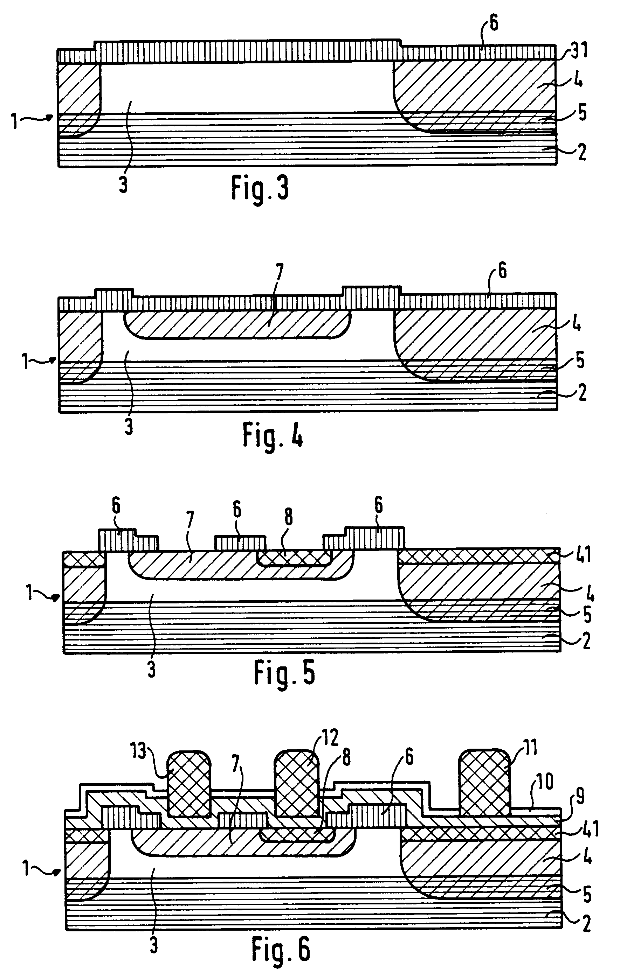

Die Herstellung eines derartigen Transistors wird nun anhand der in den Figuren 3 bis 6 dargestellten Verfahrensschritten erläutert.

Ausgehend von einem Grundkörper 1 vom n-Leitungstyp, bestehend aus zwei Schichten, von denen die untere Schicht 2 eine höhere Dotierung, also n⁺⁺-Leitfähigkeit, und die obere Schicht 3 eine gegenüber dieser geringere Dotierung, also n-Leitfähigkeit, aufweist, wird zunächst auf der Oberseite 31 eine Siliciumdioxidschicht 6 auf herkömmlicher Weise erzeugt und mittels bekannter Phototechnik diese zum Herstellen der Kollektorzone 4 an dem dafür vorgesehenen Bereich entfernt. Durch die erhaltene Öffnung wird danach mittels Diffusion oder Ionenimplantation mit anschließendem Temperaturprozeß in bekannter Weise die n⁺-leitende Kollektorzone 4 erzeugt, die bis in die untere Schicht 2 reicht und eine Umrandung für einen zunächst freibleibenden Mittelteil bildet, und dabei gleichzeitig durch Oxidation eine geschlossene Siliciumdioxidschicht 6 auf der Oberseite 31 wiederhergestellt (Fig.3).

Im nächsten Schritt wird in einem zweiten Photoprozeß im vorgesehenen Basisbereich im Mittelteil mittels Ätzen die Siliciumdioxidschicht 6 entfernt und die Basiszone durch die so erhaltene Öffnung mittels Einbringen von Dotierstoff (Diffusion oder Implantation) vom p-Leitungstyp erzeugt. Auch hier wird in einem Temperaturprozeß die Öffnung in der Siliciumdioxidschicht 6 oxidativ wieder geschlossen (Fig.4).

Im nächsten Schritt wird nun mittels eines dritten Photoprozesses in der Siliciumdioxidschicht 6 der Emitterbereich innerhalb der Basiszonenabdeckung geöffnet und gleichzeitig auch die Oberflächenbereiche der Kollektorzone 4 freigelegt. Zusammen mit dem Einbringen von Dotierstoff (Diffusion oder Ionenimplantation) zur Herstellung der n-leitenden Emitterzone 8 wird in der Kollektorzone 3 eine höher dotierte Oberflächenschicht 41 gleicher Eindringtiefe wie die Emitterzone 8 erzeugt, die für einen besonders niederohmigen Anschluß des noch aufzubringenden Metallkontaktes sorgt.

In einem vierten Photoprozeß wird nunmehr die Kontaktöffnung für die Basiszone 7 innerhalb der Siliciumdioxidschicht 6 geöffnet. Man erhält damit die in Fig.5 gezeigte Struktur.

Anschließend wird die gesamte Oberfläche des Halbleiterbauelements mit einer Metallschicht 9 aus vorzugsweise Palladium überzogen und darauf eine Photolackschicht 10 aufgebracht. In diese werden nunmehr die für die Anbringung der Kontakt-Bumps in dem jeweiligen Bereich der aktiven Zonen erforderlichen Öffnungen in einem fünften Photoprozeß hergestellt und dann die jeweiligen Kontakt-Bumps 11, 12, 13 im zugehörigen Zonenbereich, Kollektorzone 3, Basiszone 6, Emitterzone 7, galvanisch aufwachsen gelassen, wobei als Kontaktmaterial vorzugsweise Silber Anwendung findet, das gegebenenfalls für die Lötmontage ohne Flußmittel vergoldet werden kann (Fig.5).

Nach dem Ablacken wird mittels Ultraschall das auf der Siliciumdioxidschicht 6 nur schwach haftende Metall entfernt, und man erhält somit die in Fig.2 gezeigte Struktur des fertigen Bauelements. Dieses kann nach seiner Fertigstellung zum Schutz gegen Beschädigung oder Verschmutzung noch durch eine Passivierungsschicht wie z.B. Polyimid abgedeckt werden.

## Patentansprüche

1. Bipolarer Bump-Transistor, mit
- einem Trägerkörper (1) eines ersten Leitungstyps, der aus einer unteren Schicht (2) hoher Dotierung und einer oberen Schicht (3) von gegenüber dieser schwächeren Dotierung besteht,
- einer unter Ausbildung einer Umrandung von der Oberfläche (31) der oberen Schicht (3) bis in die unteren Schicht (2) sich erstreckenden hochdotierten Kollektorzone (4) des ersten Leitungstyps,
- einer Basiszone (7) eines zweiten Leitungstyps, die im Abstand zur Kollektorzone (4) innerhalb der Umrandung in der oberen Schicht (3) angeordnet ist,
- einer in die Basiszone (7) eingelassenen Emitterzone (8) des ersten Leitungstyps,
- auf der Oberfläche (31) angeordneten, die Zonen (4), (7), (8) teilweise abdeckenden Metallschichten (91, 92, 93), die durch eine Isolierschicht (6) getrennt sind, und
- Kontakt-Bumps (11, 12, 13), die auf den Metallschichten (91, 92, 93) im Bereich der Zonen (4), (7), (8) angeordnet sind.

2. Transistor nach Anspruch 1, dadurch gekennzeichnet, daß die Isolierschicht (6) aus Siliciumdioxid besteht.

3. Transistor nach Anspruch 1 oder 2, dadurch gekennzeichnet, daß die Metallschichten (91, 92, 93) aus Palladium gebildet sind.

4. Transistor nach einem der Ansprüche 1 bis 3, dadurch gekennzeichnet, daß Emitter- und Basiszone (7;8) fingerförmig ineinander greifen.

5. Transistor nach einem der Ansprüche 1 bis 4, dadurch gekennzeichnet, daß die obere Schicht (3) eine Epitaxieschicht ist.

6. Verfahren zum Herstellen eines Transistors nach einem der Ansprüche 1 bis 5, gekennzeichnet durch die folgenden Schritte:
a) Bereitstellen eines Trägerkörpers (1) eines ersten Leitungstgps, der aus einer unteren Schicht (2) hoher Dotierung und einer oberen Schicht (3) von gegenüber dieser schwächeren Dotierung besteht,
b) Aufbringen einer Siliciumdioxidschicht (6) auf der Oberfläche (31) des Trägerkörpers 1 und Herstellen einer Öffnung für den Kollektorbereich mittels eines ersten Photoprozesses,
c) Einbringen von Dotierstoff des ersten Leitungstyps zur Erzeugung der Kollektorzone (4) unter gleichzeitiger Wiederherstellung der abdeckenden Isolierschicht (6),
d) Herstellen der Öffnung für den Basisbereich durch einen zweiten Photoprozess und Einbringen von Dotierstoff eines zweiten Leitungstyps, mit gleichzeitiger Wiederherstellung der abdeckenden Isolierschicht (6),
e) Herstellen einer Öffnung für den Emitterbereich und gleichzeitig erneute Öffnung des Kollektorbereiches mittels eines dritten Photoprozesses,
f) Einbringen von Dotierstoff des ersten Leitungstyps in die Öffnungen zur Ausbildung der Emitterzone (6) und gleichzeitiger Erhöhung der Dotierung im Oberflächenbereich (41) der Kollektorzone (4),
g) Öffnen des Kontaktfensters für die Basiszone (7) mittels eines vierten Photoprozesses,
h) Aufdampfen einer Metallschicht (9),
i) Abdecken der Metallschicht (9) mit einer Photolackschicht (10) und strukturieren derselben in einem fünften Photoprozeß unter Ausbildung von Öffnungen in den Bereichen der anzubringenden Kontakt-Bumps (11, 12, 13), j) Aufwachsenlassen der Kontakt-Bumps (11, 12, 13) in den Öffnungen der Photolackschicht (10)
k) Entfernen der Photolackschicht (10) und partielle Entfernung der Metallschicht (9).

7. Verfahren nach Anspruch 6, dadurch gekennzeichnet, daß das Einbringen der Dotierstoffe durch Ionenimplantation mit nachfolgendem Eintreiben erfolgt.

8. Verfahren nach Anspruch 6, dadurch gekennzeichnet, daß das Einbringen der Dotierstoffe durch Diffusion erfolgt.

9. Verfahren nach einem der Ansprüche 6 bis 8, dadurch gekennzeichnet, daß die Isolierschicht (6) aus Siliciumdioxid gebildet wird.

## Claims

1. Bipolar bump transistor comprising
- a substrate (1) of a first conductivity type consisting of a heavily doped lower layer (2) and a more lightly doped upper layer (3),
- a heavily doped collector region (4) of the first conductivity type which extends from the surface (31) of the upper layer (3) into the lower layer (2) and forms a boundary,
- a base region (7) of a second conductivity type contained in the upper layer (3) within the boundary and at a distance from the collector region (4),
- an emitter region (8) of the first conductivity type embedded in the base region (7),
- metal layers (91, 92, 93) on the surface (31) which partly cover the collector region (4), the base region (7), and the emitter region (8) and are separated by an insulating layer (6), and
- contact bumps (11, 12, 13) disposed on the metal layers (91, 92, 93) in the areas of the collector region (4), the base region (7), and the emitter region (8).

2. A transistor as claimed in claim 1, characterized in that the insulating layer (6) is made of silicon dioxide.

3. A transistor as claimed in claim 1 or 2, characterized in that the metal layers (91, 92, 93) are made of palladium.

4. A transistor as claimed in any one of claims 1 to 3, characterized in that the emitter and base regions (7, 8) are interdigitated.

5. A transistor as claimed in any one of claims 1 to 4, characterized in that the upper layer (3) is an epitaxial layer.

6. Method of manufacturing a transistor as claimed in any one of claims 1 to 5, characterized by the following steps:
a) providing a substrate (1) of a first conductivity type consisting of a heavily doped lower layer (2) and a more lightly doped upper layer (3);
b) depositing a silicon-dioxide layer (6) on the surface (31) of the substrate (1) and removing the silicon-dioxide layer (6) in a first photoetch step where the collector region is to be formed.
c) introducing dopants of the first conductivity type to form the collector region (4) and simultaneously restoring the covering insulating layer (6);
d) opening a hole in the base area in a second photoetch step and introducing dopants of a second conductivity type and simultaneously restoring the covering insulating layer (6);
e) opening a hole in the emitter area and simultaneously reexposing the surface area of the collector region in a third photoetch step;
f) introducing dopants of the first conductivity type to form the emitter region (8) and simultaneously increasing the dopant concentration in the surface area (41) of the collector region (4);
g) opening a contact window for the base region (7) in a fourth photoetch step;
h) depositing a metal layer (9) by evaporation;
i) covering the metal layer (9) with a photoresist layer (10) and patterning the same in a fifth photoetch step to form holes for the contact bumps (11, 12, 13);
j) growing the contact bumps (11, 12, 13) in the holes in the photoresist layer (10), and
k) removing the photoresist layer (10) and parts of the metal layer (9).

7. A method as claimed in claim 6, characterized in that the dopants are introduced by ion implantation followed by a drive-in step.

8. A method as claimed in claim 6, characterized in that the dopants are introduced by diffusion.

9. A method as claimed in any one of claims 6 to 8, characterized in that the insulating layer (6) is made of silicon dioxide.

## Revendications

1. Transistor bipolaire à protubérances, comprenant :
- un corps-substrat (1) d'un premier type de conduction, qui est constitué d'une couche inférieure (2) à dopage élevé et d'une couche supérieure (3) à dopage plus faible que la couche inférieure,
- une zone de collecteur (4) à dopage élevé, du premier type de conduction, qui s'étend de la surface supérieure (31) de la couche supérieure (3) jusque dans la couche inférieure (2), en formant un entourage,
- une zone de base (7) d'un second type de conduction, qui est disposée dans la couche supérieure (3) à distance de la zone de collecteur (4) et à l'intérieur de l'entourage,
- une zone d'émetteur (8) du premier type de conduction qui s'enfonce dans la zone de base (7),
- des couches métalliques (91, 92, 93) qui sont disposées sur la surface supérieure (31) et couvrent partiellement les zones (4), (7), (8) et qui sont isolées par une couche isolante (6) et
- des protubérances de contact (11, 12, 13) qui sont disposées sur les couches métalliques (91, 92, 93) dans le domaine des zones (4), (7), (8).

2. Transistor selon la revendication 1, caractérisé en ce que la couche isolante (6) est en silice.

3. Transistor selon l'une des revendications 1 et 2, caractérisé en ce que les couches métalliques (91, 92, 93) sont en palladium.

4. Transistor selon l'une des revendications 1 à 3, caractérisé en ce que la zone d'émetteur (7) et la zone de base (8) s'interpénètrent en forme de doigts.

5. Transistor selon l'une des revendications 1 à 4, caractérisé en ce que la couche supérieure (3) est une couche d'épitaxie.

6. Procédé de réalisation d'un transistor selon l'une des revendications 1 à 5, caractérisé par les phases suivantes :
a) préparation d'un corps-substrat (1) d'un premier type de conduction qui est constitué d'une couche inférieure (2) à dopage élevé et d'une couche supérieure (3) à dopage plus faible que cette couche inférieure,
b) dépôt d'une couche de silice (6) sur la surface supérieure (31) du corps-substrat (1) et réalisation d'une ouverture correspondant au domaine du collecteur au moyen d'un premier phototraitement,
c) apport d'une substance de dopage du premier type de conduction en vue de réaliser la zone de collecteur (4) tout en reconstituant simultanément la couche isolante (6) de couverture,
d) réalisation de l'ouverture correspondant au domaine de la base au moyen d'un deuxième phototraitement et apport d'une substance de dopage d'un second type de conduction, en reconstituant en même temps la couche isolante (6) de couverture,
e) réalisation d'une ouverture correspondant au domaine de l'émetteur et nouvelle ouverture simultanée du domaine du collecteur au moyen d'un troisième phototraitement,
f) apport d'une substance de dopage du premier type de conduction dans les ouvertures en vue de former la zone d'émetteur (8) et accroissement simultané du dopage dans le domaine de surface supérieure (41) de la zone de collecteur (4),
g) ouverture de la fenêtre de contact correspondant à la zone de base (7) au moyen d'un quatrième phototraitement,
h) métallisation sous vide d'une couche métallique (9),
i) couverture de la couche métallique (9) au moyen d'une couche de photorésist (10) et structuration de cette couche dans un cinquième phototraitement, tout en formant des ouvertures dans les domaines des protubérances de contact (11, 12, 13) à mettre en place,
j) opération consistant à faire croître les protubérances de contact (11, 12, 13) dans les ouvertures de la couche de photorésist (10) et
k) suppression de la couche de photorésist (10) et suppression partielle de la couche métallique (9).

7. Procédé selon la revendication 6, caractérisé en ce que l'apport des substances de dopage s'effectue par implantation d'ions suivie d'un enfoncement.

8. Procédé selon la revendication 6, caractérisé en ce que l'apport des substances de dopage s'effectue par diffusion.

9. Procédé selon l'une des revendications 6 à 8, caractérisé en ce que la couche isolante (6) est réalisée en silice.
